# EUROPÄISCHE PATENTANMELDUNG

(11) **EP 1 248 290 A2**
(43) Veröffentlichungstag der Anmeldung: **09.10.2002**
(21) Anmeldenummer: 02100344.7
(22) Anmeldetag: 05.04.2002
(51) Int. Cl.: H01L 21/331

(54) **Herstellung eines lateralen Bipolartransistors**

(30) Priorität: 07.04.2001 DE 10117558
(71) Anmelder: Philips Corporate Intellectual Property GmbH, 20099 Hamburg (DE); Koninklijke Philips Electronics N.V., 5621 BA Eindhoven (NL)
(72) Erfinder: Strobel, Lothar, c/o Philips Corp. Int. Prop. GmbH, 52066, Aachen (DE)
(74) Vertreter: Volmer, Georg, Dipl.-Ing.

(57) **Zusammenfassung**

Durch ein Verfahren zur Herstellung eines lateralen Bipolartransistors mit einer Kollektorzone und einer Basiszone in einer SOI-Waferscheibe mit einer isolierenden Schicht, einer Siliciumschicht über der isolierenden Schicht,
mit einer Schutzschicht aus Oxid über der Siliciumschicht,
mit Gräben durch die Schutzschicht und die Siliciumschicht bis zu der isolierenden Schicht mit im wesentlichen lateralen Wänden, die durch im wesentlichen laterale Flächen der Schutzschicht und der Siliciumschicht begrenzt sind,
durch Implantation von Dotierstoffen in der Siliciumschicht,
bei dem die Implantation auf einer der im wesentlichen lateralen Fläche der Siliciumschicht erfolgt, kann ein lateraler Bipolartransistor mit einer geringen lateralen Weite des dotierten Gebietes erhalten werden.

Es ist bevorzugt, dass die Basiszone durch Implantation unter einem Verkippungswinkel von 30 bis 60 ° zwischen der Waferscheibennormalen und der Ionenstrahlrichtung der Ionenimplantation auf einer der im wesentlichen lateralen Fläche der Siliciumschicht gebildet wird.

## Beschreibung

Die Erfindung betrifft die Herstellung eines lateralen Bipolartransistors in SOI-Technik.

Laterale Bipolartransistoren sind aufgrund der steigenden Nachfrage nach tragbaren, batteriebetriebenen Geräten für Anwendungen in der Telekommunikation, die einen niedrigen Stromverbrauch haben, ins Zentrum technologischer Anstrengungen gerückt. Laterale bipolare Transistoren sind besonders geeignet für Frontend-Anwendungen mit niedrigem Stromverbrauch in einem mittleren Frequenzbereich.

Aus dem Artikel von R. Dekker, W.T.A. v.d. Einden, H.G.R. Maas, "An Ultra LowPower Lateral Bipolar Polysilicon Emitter Technology on SOI", 1993 IEEE, IEDM 93-75, 4.4.1 ist eine Verfahren zur Herstellung derartiger lateraler Bipolartransistoren bekannt, bei dem Basis und Emitter durch konventionelle Ionenimplantation hergestellt werden. Um die aktive Basisfläche freizulegen, muß das Silicium an der Basisseite anschließend an die Ionenimplantation durch anisotropes Ätzen freigelegt werden. Dies Herstellungsverfahren ist jedoch mit verschiedenen Nachteilen behaftet. Für den Ätzvorgang ist kein Endpunktsignal möglich, Stufenhöhen bis zu 0,6µm bereiten Schwierigkeiten beim anisotropen Ätzen und der Polyemitter liegt auf einer geätzten Flanke auf.

Es ist daher die Aufgabe der vorliegenden Erfindung ein Verfahren zur Herstellung eines lateralen Bipolartransistors in SOI-Technik anzugeben, bei dem die angegebenen Nachteile vermieden werden.

Erfindungsgemäß wird die Aufgabe gelöst durch eine Verfahren zur Herstellung eines lateralen Bipolartransistors mit einer Kollektorzone und einer Basiszone in einer SOI-Waferscheibe mit einer isolierenden Schicht, einer Siliciumschicht über der isolierenden Schicht, mit einer Schutzschicht aus Oxid über der Siliciumschicht, mit Gräben durch die Schutzschicht und die Siliciumschicht bis zu der isolierenden Schicht mit im wesentlichen lateralen Wänden, die durch im wesentlichen lateralen Flächen der Schutzschicht und der Siliciumschicht begrenzt sind, durch Implantation von Dotierstoffen in der Siliciumschicht, bei dem die Implantation auf einer der im wesentlichen lateralen Fläche der Siliciumschicht erfolgt.

Im Rahmen der vorliegenden Erfindung ist es besonders bevorzugt, dass die Basiszone durch Implantation auf einer der im wesentlichen lateralen Fläche der Siliciumschicht gebildet wird.

Wesentlich für Funktionsweise eine lateralen Bipolartransistors ist eine schmale Basiszone, damit die Ladungsträger aus dem Emitterraum durch die Grenzschicht zwischen Emitterzone und Basiszone und durch die Basiszone hindurchwandern und somit die Vorgänge an der Grenzschicht zwischen Basiszone und Kollektorzone beeinflussen können, dadurch erfolgt sie Steuerung des Stromverlaufs zwischen Basis und Kollektor.

Bei den bekannten Verfahren wird die Basiszone durch konventionelle Ionenimplantation, laterale Ausdiffusion des Dotierstoffes und anschließendes Abätzen eines Teils der Siliciumschicht hergestellt. Die dabei verwendeten Depositions- und Ätzverfahren unterliegen Streuungen und beeinflussen daher die laterale Weite des dotierten Gebietes

Es ist weiterhin bevorzugt, dass die Implantation unter einem Verkippungswinkel von 30 bis 60 ° zwischen der Waferscheibennormalen und der Ionenstrahlrichtung der Ionenimplantation erfolgt.

Nachfolgend wird die Erfindung anhand von zwei Figuren weiter erläutert.
- Fig. 1: zeigt einen Querschnitt durch einen lateralen Bipolartransistor mit einem Polysiliconemitter
- Fig. 2: zeigt den erfindungsgemäßen Verfahrensschritt der Ionenschrägimplantation der Basis.

Ein Bipolartransistor umfaßt drei verschieden dotierte n- bzw. p-Bereiche in einem Halbleiterkristall (meistens ein Siliciumkristall) mit zwei dazwischen liegenden p-n-Übergängen. Die beiden äußeren Bereiche vom gleichen Leitungstyp nennt man Emitterzone 1 und Kollektorzone 2, den höchstens einige µm dicken mittleren Bereich Basiszone 3, die an sie angebrachten Elektroden werden als Emitter 4, Basis und Kollektor 5 bezeichnet. Der Minoritätsträgerstrom durch die Basis wird durch ein (eingebautes) Driftfeld 6 zwischen Kollektor und Basis unterstützt, das durch eine inhomogene Störstellenverteilung zwischen Kollektor und Basis entsteht.

Ein lateraler Bipolartransistor ist eine Bipolartransistor, bei dem Emitter, Basis und Kollektor im Gegensatz zum Planartransistor horizontal (lateral) angeordnet sind. Der Injektionsstrom vom Emitter zum Kollektor fließt damit in lateraler Richtung entlang der Oberfläche.

Laterale Bipolartransistoren in SOI Technik worden in dünnen halbleitenden Schichten auf isolierenden Trägern hergestellt. In einem auch vertikal relativ weit ausgsdehnten und für den Leitungstyp der Basis dotierten Bereich werden durch lokal begrenztes Umdotieren Zonen für Emitter und Kollektor hergestellt.

Nach einer bevorzugten Ausführungsform der Erfindung wird ein lateraler Bipolartransistor mit Polysiliconemitter in SOI-Technik hergestellt.

Ausgangspunkt für das erfindungsgemäße Verfahren ist der in Fig. 2 dargestellte Aufbau.

Als Substratmaterial wird dabei ein Siliciumwafer 7 verwendet, der von einer Oxidschicht 8 der Dicke dₒₓ₂ überzogen ist. Auf diese Oxidschicht kommt die Siliciumschicht 9 der Dicke d_{Si}, über der im Bereich der Driftregion der Oxidblock Wₑₚᵢ 10 mit der Dicke dₒₓ₁ liegt. Ein solcher Schichtaufbau kann auf unterschiedliche Weise erreicht werden: Ein übliches Verfahren sind Abscheiden von polykristallinem Silicium auf einem zuvor oxidiertem Siliciumträger mit anschließender Rekristallisation. Geringere Defektdichten lassen sich in der Regel durch Verkleben zweier zuvor oxidierter Halbleiterscheiben und anschließendes Abätzen einer Halbleiterschicht bis zur gewünschten Filmdicke erzielen (BESOI-Verfahren). Bei geringen Filmdicken kann auch das SIMOX-Verfahren verwendet werden. Dabei werden Sauerstoffatome in einen einkristallinen Wafer implantiert. Diese häufen sich in einer Schicht unterhalb der Halbleiteroberfläche. In einem anschließenden Temperaturschritt bildet sich eine Schicht aus SiO₂ unter einem dünnen halbleitenden Film.

In der Siliciumschicht kann erfindungsgemäß ein npn- oder ein pnp-Transistor mit einer der folgenden Dotiersequenzen hergestellt werden: n⁺pn⁻n⁺ (Standardabfolge), n⁺npn⁻n⁺ (n-Pufferschicht zwischen Basis und Emitter zur Reduzierung von Durchbruch, Leckraten und Kapazitäten), n⁺npn⁻nn⁺(n⁻-Pufferschicht zwischen Basis und Kollektor).

Die Dicke der Siliciumschicht d_{Si} kann zwischen 20 nm und 2µm betragen, die Dotierungshöhe dieser Schicht liegt zwischen 10¹⁵cm⁻³ und 10¹⁸cm⁻³, wobei je nach Transistortyp Donatoren oder Akzeptoren zugesetzt werden.

Zunächst werden photolithografisch die Bereiche festgelegt, die für die späteren Transistorbereiche vorgesehen sind. Die vertikalen Abmessungen des Transistors ergeben sich automatisch durch die verwendete Dicke der ursprünglichen Siliciumschicht auf dem SOI-Substrat.

Die Siliciumschicht wird mit einer Grunddotierung versehen. Die außerhalb des für den Transistor vorgesehenen Bereiches liegenden Teile der Siliciumschicht werden weggeätzt, so dass ein Graben 11 entsteht. Der bis zur Isolationsschicht reichende Graben bildet die vollständige dielektrische Isolation des Transistors nach außen.

Nachdem der Transistor isoliert ist, wird eine 400 nm dicke TEOS-Schicht abgeschieden und strukturiert. Dadurch wird ein Oxidblock 10 geformt, dessen Breite die Breite der Driftregion bestimmt.

Danach wird zunächst die Kollektorzone durch eine photolithografisch erzeugte Maske festgelegt und durch Implantation mit Dotierstoff hergestellt. Der Dotierstoff kann beispielsweise Posphor in Form von PH₃ sein, der mit einer Dosis von 5.0 10²⁰cm⁻³ implantiert wird. Gegebenenfalls erfolgt noch ein Ausheilungs- oder Diffusionsschritt. Danach wird die Basiszone 3 durch Implantation auf der im wesentlichen lateralen Fläche der Siliciumschicht 12 gebildet. Der Dotierstoff kann beispielsweise Bor in Form von BH₃ oder BF3sein. Die Dosis der Implantation für die Basiszone wird so eingestellt, dass die Dotierung Werte von 10¹⁷ cm⁻³ erreicht.

Wie in Fig. 2 gezeigt, erfolgt die Implantation bevorzugt unter einem Verkippungswinkel von 30 bis 60 ° zwischen der Waferscheibennormalen und der Ionenstrahlrichtung der Ionenimplantation. Beachtet werden muß, dass durch die Schrägimplantation die wirksame Implantationsenergie reduziert ist.

Gleichzeitig kann die Scheibe noch gewobbelt, kontinuierlich oder jeweils um 90° gedreht werden.

Gegebenenfalls erfolgt auch hier noch ein Ausheilungs- oder Diffusionsschritt. Nachdem die Basiszone vertikal und nicht lateral ausdiffundiert wird, kann die Basiszone sehr genau mit sehr schmaler lateraler Abmessung z.B. 40 nm, hergestellt werden.

Anschließend wird der Polysiliconemitter 4 abgeschieden, implantiert, fotolithografisch strukturiert und diffundiert.

Danach wird die dielektrische Schicht 12 abgescheiden, die Kontaktlöcher geätzt und die **Kontakte** gebildet.

Bei der beschriebenen Ausführungsform der Erfindung ist die Basis jeweils seitlich herausgezogen, d.h. die Basiszone verläuft streifenförmig senkrecht zur Zeichenebene der Figuren und endet in einer hochdotierten Basisanschlusszone, die als Basisanschluß dient und entsprechend kontaktiert wird. Diese Kontaktierung kann direkt durch Metall oder indirekt durch eine Kontaktschicht aus Polysilicium erfolgen.

## Patentansprüche

1. Verfahren zur Herstellung eines lateralen Bipolartransistors mit einer Kollektorzone und einer Basiszone in einer SOI-Waferscheibe mit einer isolierenden Schicht, einer Siliciumschicht über der isolierenden Schicht,
mit einer Schutzschicht aus Oxid über der Siliciumschicht,
mit Gräben durch die Schutzschicht und die Siliciumschicht bis zu der isolierenden Schicht mit im wesentlichen lateralen Wänden, die durch im wesentlichen lateralen Flächen der Schutzschicht und der Siliciumschicht begrenzt sind,
durch Implantation von Dotierstoffen in der Siliciumschicht,
**dadurch gekennzeichnet,**
**dass** die Implantation auf einer der im wesentlichen lateralen Fläche der Siliciumschicht erfolgt.

2. Verfahren gemäß Anspruch 1,
**dadurch gekennzeichnet,**
**dass** die Basiszone durch Implantation auf einer der im wesentlichen lateralen Fläche der Siliciumschicht gebildet wird.

3. Verfahren gemäß Anspruch 1,
**dadurch gekennzeichnet,**
**dass** die Implantation unter einem Verkippungswinkel von 30 bis 60 ° zwischen der Waferscheibennormalen und der Ionenstrahlrichtung der Ionenimplantation erfolgt.
